# EUROPÄISCHE PATENTSCHRIFT

(11) **EP 4 386 345 B1**
(45) Veröffentlichungstag und Bekanntmachung des Hinweises auf die Patenterteilung: **25.02.2026**
(21) Anmeldenummer: 23209614.9
(22) Anmeldetag: 14.11.2023
(51) Int. Cl.: G01L 1/16, G01L 1/26, H10N 30/30, H10N 30/80

(54) **VERFAHREN UND VORRICHTUNG ZUR MESSUNG EINER KRAFTEINWIRKUNG**
METHOD AND DEVICE FOR MEASURING A FORCE
PROCÉDÉ ET DISPOSITIF DE MESURE D'UNE FORCE

(30) Priorität: 15.12.2022 DE 102022213724
(43) Veröffentlichungstag der Anmeldung: 19.06.2024
(73) Patentinhaber: AUMOVIO Germany GmbH, 60488 Frankfurt am Main (DE)
(72) Erfinder: Frolov, Vitalis, 60488 Frankfurt am Main (DE)
(74) Vertreter: Aumovio Corporation

(56) Entgegenhaltungen:
- EP-A2- 0 325 903
- DE-A1- 102013 222 759
- GB-A- 2 122 746
- JP-A- 2001 115 886
- US-A1- 2015 123 931

## Beschreibung

Die vorliegende Erfindung betrifft ein Verfahren und eine Vorrichtung zur Messung einer Krafteinwirkung. Die Erfindung betrifft zudem ein Eingabegerät, das eine solche Vorrichtung oder ein solches Verfahren nutzt.

Zur Realisierung von Eingabegeräten mit aktivem haptischen Feedback ist die Bestimmung der Betätigungskraft während des Betätigungsvorgangs von Vorteil und oftmals auch gefordert. Ein Betätigungsvorgang ist stets dynamisch und besteht üblicherweise aus den Phasen Berühren, Drücken (bei Tasten), Verharren (bei Schiebereglern), Entspannen und Loslassen.

Zur Kraftmessung sind bereits verschiedene Verfahren, basierend z.B. auf einer Wegmessung oder einer Dehnungsmessung, und Sensoren realisiert und im Gebrauch. Bei den Sensoren seien beispielhaft optische, akustische, kapazitive, induktive, piezoresistive, piezoelektrische, induktive oder auf Dehnungsmessstreifen basierende Sensoren genannt.

Die üblichen Verfahren und Sensoren werden oftmals den Anforderungen von Herstellern im Automobilbereich nicht gerecht, so dass sie in diesem Umfeld nicht oder nur bedingt einsetzbar sind. Die Anforderungen betreffen dabei beispielsweise die Empfindlichkeit, den benötigten Bauraum, den Preis, die Skalierbarkeit, die Schnelligkeit, sowie die Unempfindlichkeit gegenüber mechanischen Störeinflüssen und Fertigungstoleranzen. Problematisch ist insbesondere das meist sehr kostenintensive mechanische und elektronische Konzept.

Eine Sensierung einer Krafteinwirkung, die beinahe ohne eine mechanische Verformung auskommt, kann mittels eines piezoelektrischen Sensors erfolgen. Piezoelektrische Sensoren basieren auf dem Prinzip der elektrischen Ladungsverschiebung bei mechanischer Verformung. Sie haben einen sehr hohen Innenwiederstand. Die Messung der Ladungsmenge stellt je nach Anforderung eine gewisse Herausforderung dar, da eine Messanordnung in der Regel einen Ladungsausgleich bewirkt. Zudem erfolgt die Änderung der Messgröße des piezoelektrischen Sensors sehr schnell, so dass die Auswertung mit einer hochpräzisen Elektronik erfolgen muss.

Piezoelektrische Sensoren werden oftmals mit integrierten Ladungsverstärkern verschaltet. Durch eine Krafteinwirkung auf das Piezoelement wird eine der Kraft proportionale elektrische Ladungsmenge erzeugt. Diese Ladungsmenge wird durch eine Integratorschaltung in eine Spannung umgewandelt. Idealerweise liefert die analoge Elektronik als Ausgangswert einen statischen Wert proportional zur Dehnung.

Vor diesem Hintergrund beschreibt EP 0 253 016 A1 eine Ladungsverstärkerschaltung, z.B. für einen piezoelektrischen Messgeber. Die Ladungsverstärkerschaltung weist einen Operationsverstärker mit einem Integrationskondensator zwischen seinem invertierenden Eingang und seinem Ausgang auf sowie eine Rückstelleinrichtung mit einem in der Rückstellphase geschlossenen Schalter für die Entladung des Integrationskondensators.

In der Regel liefern die integrierten Ladungsverstärker sehr kurze Pulse, die mit einer e-Funktion abfallen. Die Auswertung dieser Pulse ist sehr aufwendig und mit Ungenauigkeiten behaftet. Zudem erfordert die Auswertung hohe Abtastraten.

Aus den Druckschriften US 2015/0123931 A1, GB 2 122 746 A und JP 2001 115886 A sind Verfahren und Vorrichtungen gemäß dem jeweiligen Oberbegriff der unabhängigen Ansprüche bekannt.

Es ist eine Aufgabe der vorliegenden Erfindung, verbesserte Lösungen zur Messung einer Krafteinwirkung bereitzustellen.

Diese Aufgabe wird durch ein Verfahren mit den Merkmalen des Anspruchs 1, durch eine Vorrichtung mit den Merkmalen des Anspruchs 5 sowie durch ein Eingabegerät mit den Merkmalen des Anspruchs 8 gelöst. Bevorzugte Ausgestaltungen der Erfindung sind Gegenstand der abhängigen Ansprüche.

Gemäß einem ersten Aspekt der Erfindung umfasst ein Verfahren zur Messung einer Krafteinwirkung die Schritte:
- Generieren eines aus einer Krafteinwirkung auf einen Kraftsensor resultierenden Spannungspulses mittels eines Ladungsverstärkers; und
- Speichern eines aus dem Spannungspuls abgeleiteten Spannungswertes in einem Speicherkondensator mittels eines Stromspiegels.

Gemäß einem weiteren Aspekt der Erfindung weist eine Vorrichtung zur Messung einer Krafteinwirkung auf:
- einen Ladungsverstärker zum Generieren eines aus einer Krafteinwirkung auf einen Kraftsensor resultierenden Spannungspulses; und
- einen Stromspiegel zum Speichern eines aus dem Spannungspuls abgeleiteten Spannungswertes in einem Speicherkondensator.

Bei der erfindungsgemäßen Lösung wird der Spannungspegel des Ausgangs des Integrators bzw. des Ladungsverstärkers mithilfe eines Stromspiegels in einem Kondensator gespeichert, so dass die Ladung nicht abfließen kann. Dies ermöglicht eine längere Auswertezeit und hält den Signalpegel über einen längeren Zeitraum konstant. Dabei ist der sich ergebene Spannungswert umgekehrt proportional zur Krafteinwirkung. Durch den Stromspiegel werden die Effekte einer eventuellen Signalverschiebung reduziert. Zudem können die Transistoren des Stromspiegels temperaturkompensiert ausgestaltet sein, so dass Temperatureinflüsse auf die Messung reduziert werden. Der resultierende Spannungswert des Kondensators kann von einer Auswerteeinheit erfasst und ausgewertet werden, z.B. von einem Mikrocontroller über dessen ADC-Eingang (ADC: Analog-to-Digital Converter; Analog-Digital-Wandler). Dabei können sowohl eine Betätigung als auch eine Entlastung des Kraftsensors ausgewertet werden.

Gemäß einem Aspekt der Erfindung wird das Speichern der Ausgangsspannung im Speicherkondensator durch einen Auslöseimpuls einer Komparatorschaltung ausgelöst. Bei einer Betätigung des Kraftsensors sinkt der Pegel dann umgekehrt proportional zur Kraft. Bei einer Entlastung geht der Pegel wieder zurück in den Ausgangszustand.

Gemäß einem Aspekt der Erfindung weist die Komparatorschaltung zwei Komparatoren auf, die das Speichern eines positiven und eines negativen aus dem Spannungspuls abgeleiteten Spannungswertes ermöglichen. Dies erlaubt es, abwechselnd einen positiven und einen negativen Puls zu speichern. Bei einem erneuten Auslöseimpuls wird der Kondensator somit umgeladen. Betätigung und Entlastung des Kraftsensors haben in diesem Fall jeweils einen eigenen Spannungswert, der umgekehrt proportional zur Krafteinwirkung ist.

Gemäß einem Aspekt der Erfindung ist der Kraftsensor ein piezoelektrischer Sensor oder ein elektrodynamischer Sensor. Ein piezoelektrischer Sensor erlaubt die Erfassung einer Krafteinwirkung nahezu ohne eine mechanische Verformung, was insbesondere für Anwendungen im Automobilbereich vorteilhaft ist. Anstelle eines piezoelektrischen Sensors können alternativ auch elektrodynamische Sensoren verwendet werden.

Vorzugsweise wird eine erfindungsgemäße Lösung in einer Maschine genutzt, z.B. in einem Fortbewegungsmittel, einer Industriemaschine oder einem Haushaltsgerät. Bei dem Fortbewegungsmittel kann es sich beispielsweise um ein Kraftfahrzeug, ein Luftfahrzeug, ein Schienenfahrzeug oder ein Wasserfahrzeug handeln.

Weitere Merkmale der vorliegenden Erfindung werden aus der nachfolgenden Beschreibung und den angehängten Ansprüchen in Verbindung mit den Figuren ersichtlich.

### Figurenübersicht

- Fig. 1: zeigt schematisch ein Verfahren zur Messung einer Krafteinwirkung;
- Fig. 2: zeigt schematisch eine Vorrichtung zur Messung einer Krafteinwirkung;
- Fig. 3: zeigt eine erste Schaltung, die eine erfindungsgemäße Lösung umsetzt;
- Fig. 4: zeigt einen Verlauf einer Kondensatorspannung der Schaltung aus Fig. 3;
- Fig. 5: zeigt eine zweite Schaltung, die eine erfindungsgemäße Lösung umsetzt;
- Fig. 6: zeigt einen Verlauf einer Kondensatorspannung der Schaltung aus Fig. 5;
- Fig. 7: zeigt schematisch ein Eingabegerät, das eine erfindungsgemäße Lösung nutzt; und
- Fig. 8: zeigt schematisch eine Maschine mit einem erfindungsgemäßen Eingabegerät.

### Figurenbeschreibung

Zum besseren Verständnis der Prinzipien der vorliegenden Erfindung werden nachfolgend Ausführungsformen der Erfindung anhand der Figuren detaillierter erläutert. Gleiche Bezugszeichen werden in den Figuren für gleiche oder gleichwirkende Elemente verwendet und nicht notwendigerweise zu jeder Figur erneut beschrieben. Es versteht sich, dass sich die Erfindung nicht auf die dargestellten Ausführungsformen beschränkt und dass die beschriebenen Merkmale auch kombiniert oder modifiziert werden können, ohne den Schutzbereich der Erfindung zu verlassen, wie er in den angehängten Ansprüchen definiert ist.

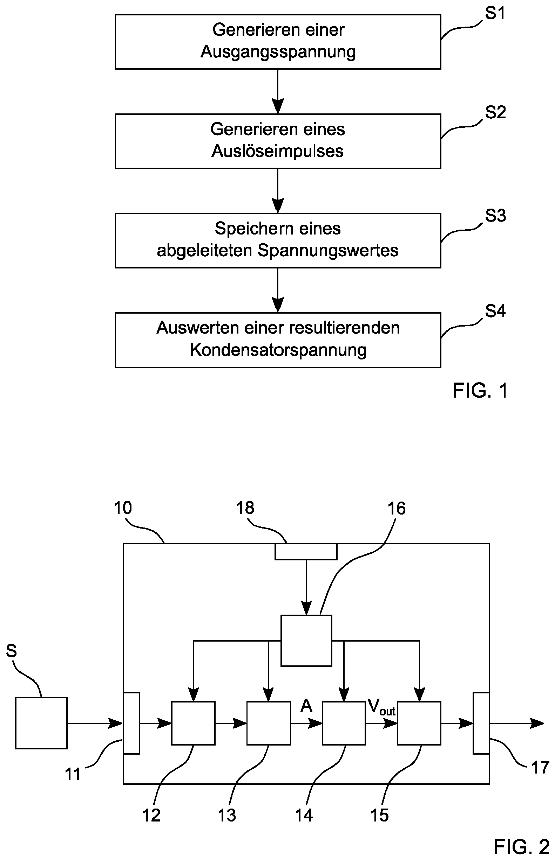

Fig. 1 zeigt schematisch ein Verfahren zur Messung einer Krafteinwirkung. In einem ersten Schritt wird mittels eines Ladungsverstärkers ein aus einer Krafteinwirkung auf einen Kraftsensor resultierender Spannungspuls generiert S1, z.B. infolge einer Betätigung einer Bedienoberfläche. Der Kraftsensor kann z.B. ein piezoelektrischer Sensor oder ein elektrodynamischer Sensor sein. Unter Verwendung dieses Spannungspulses kann mittels einer Komparatorschaltung ein Auslöseimpuls erzeugt werden S2. Ein aus dem Spannungspuls abgeleiteter Spannungswert wird nun mittels eines Stromspiegels in einem Speicherkondensator gespeichert S3. Die daraus resultierende Kondensatorspannung kann mittels einer Auswerteeinheit ausgewertet werden S4, um beispielsweise eine Nutzereingabe zu bestimmen. Die Komparatorschaltung kann alternativ auch zwei Komparatoren aufweisen, die das Speichern S3 eines positiven und eines negativen aus dem Spannungspuls abgeleiteten Spannungswertes ermöglichen.

Fig. 2 zeigt eine vereinfachte schematische Darstellung einer Vorrichtung 10 zur Messung einer Krafteinwirkung. Die Vorrichtung 10 hat einen Eingang 11, an den ein Kraftsensor S angeschlossen ist. Alternativ kann der Kraftsensor S auch Bestandteil der Vorrichtung 10 sein. Der Kraftsensor S kann z.B. ein piezoelektrischer Sensor oder ein elektrodynamischer Sensor sein. Ein Ladungsverstärker 12 ist eingerichtet, einen aus einer Krafteinwirkung auf den Kraftsensor S resultierenden Spannungspuls zu generieren. Eine Komparatorschaltung 13 ist eingerichtet, unter Verwendung dieses Spannungspulses einen Auslöseimpuls A zu erzeugen. Ein Stromspiegel 14 ist eingerichtet, einen aus dem Spannungspuls abgeleiteten Spannungswert in einem Speicherkondensator zu speichern. Es kann eine Auswerteeinheit 15 vorgesehen sein, die eingerichtet ist, eine resultierende Kondensatorspannung Vₒᵤₜ auszuwerten, um beispielsweise eine Nutzereingabe zu bestimmen. Informationen zur bestimmten Nutzereingabe können dann über einen Ausgang 17 der Vorrichtung 10 ausgegeben werden. Die Komparatorschaltung 13 kann alternativ auch zwei Komparatoren aufweisen, die das Speichern eines positiven und eines negativen aus dem Spannungspuls abgeleiteten Spannungswertes ermöglichen. Der Ladungsverstärker 12, die Komparatorschaltung 13, der Stromspiegel 14 und die Auswerteeinheit 15 können gegebenenfalls von einem Kontrollmodul 16 gesteuert werden. Es kann zudem eine Schnittstelle 18 vorgesehen sein, über die Einstellungen des Ladungsverstärkers 12, der Komparatorschaltung 13, des Stromspiegels 14, der Auswerteeinheit 15 oder des Kontrollmoduls 16 geändert werden können.

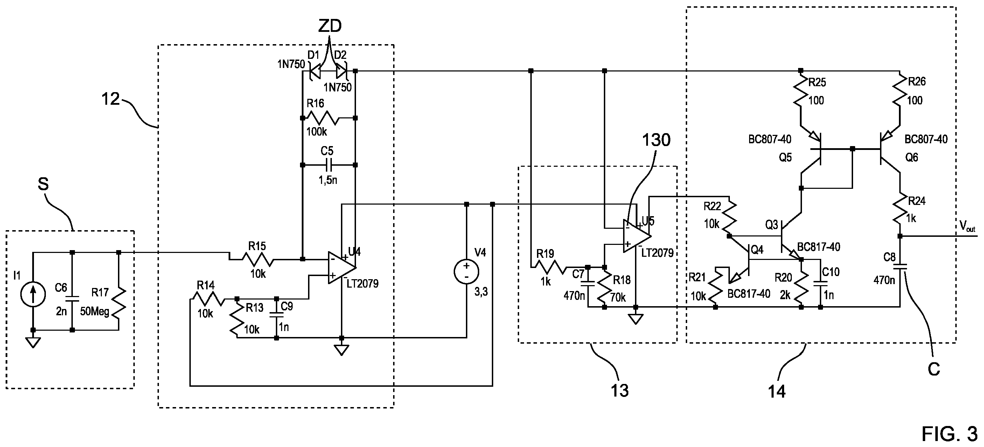

Fig. 3 zeigt beispielhaft eine erste Schaltung, die eine erfindungsgemäße Lösung umsetzt. Dabei wird eine bekannte Integratorschaltung zur Auswertung von piezoelektrischen Sensoren um eine Komparatorschaltung 13 und einen Stromspiegel 14 erweitert. Auf die einzelnen elektronischen Bauteile der Schaltung soll an dieser Stelle nicht eingegangen werden. Sie sind in der Figur benannt und dem Fachmann bekannt. Die von einem Kraftsensor S, hier ein piezoelektrischer Sensor, infolge einer Betätigung erzeugte elektrische Ladungsmenge wird von einem Ladungsverstärker 12, hier eine Integratorschaltung, in einen Spannungspuls umgewandelt. Der Spannungspegel des Ausgangs des Integrators bzw. des Ladungsverstärkers 12 wird mithilfe des Stromspiegels 14 in einem Kondensator C gespeichert, so dass die Ladung nicht abfließen kann. Die Kondensatorspannung Vₒᵤₜ wird dabei durch Zenerdioden ZD auf einen vorgegebenen Wert begrenzt, z.B. auf 2V. Ausgelöst wird die Speicherung durch Auslöseimpulse der Komparatorschaltung 13. Die in Fig. 3 dargestellte Komparatorschaltung 13 weist einen einzelnen Komparator 130 auf.

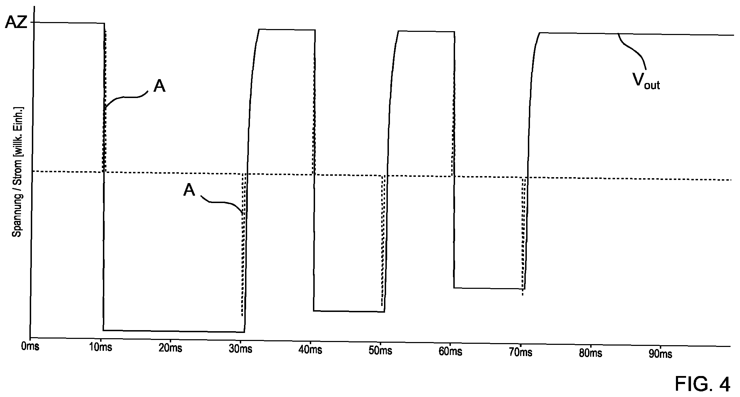

Fig. 4 zeigt einen zeitlichen Verlauf einer Kondensatorspannung Vₒᵤₜ der Schaltung aus Fig. 3. Bei einer Betätigung des Kraftsensors wird ein Auslöseimpuls A erzeugt und der Pegel sinkt umgekehrt proportional zur Kraft. Bei einer Entlastung des Kraftsensors wird erneut ein Auslöseimpuls A erzeugt und der Pegel kehrt in den Ausgangszustand AZ zurück.

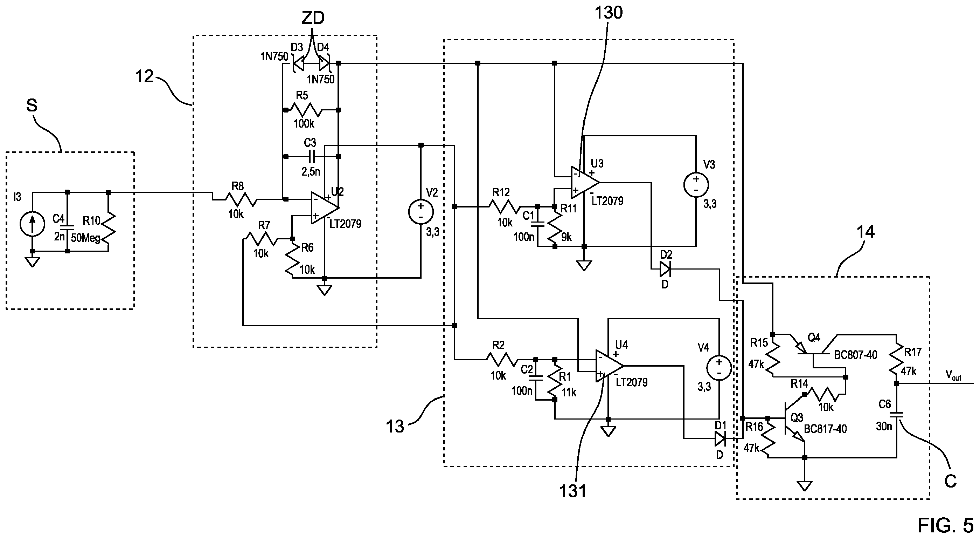

Fig. 5 zeigt beispielhaft eine zweite Schaltung, die eine erfindungsgemäße Lösung umsetzt. In dieser Ausführungsform wird die Integratorschaltung um einen Stromspiegel 14 und eine Komparatorschaltung 13 mit zwei Komparatoren 130, 131 erweitert. Auf die einzelnen elektronischen Bauteile der Schaltung soll an dieser Stelle nicht eingegangen werden. Sie sind in der Figur benannt und dem Fachmann bekannt. Grundsätzlich entspricht die Funktionsweise derjenigen der Schaltung aus Fig. 3, allerdings ermöglichen die beiden Komparatoren 130, 131 die Speicherung eines positiven und eines negativen Pulses.

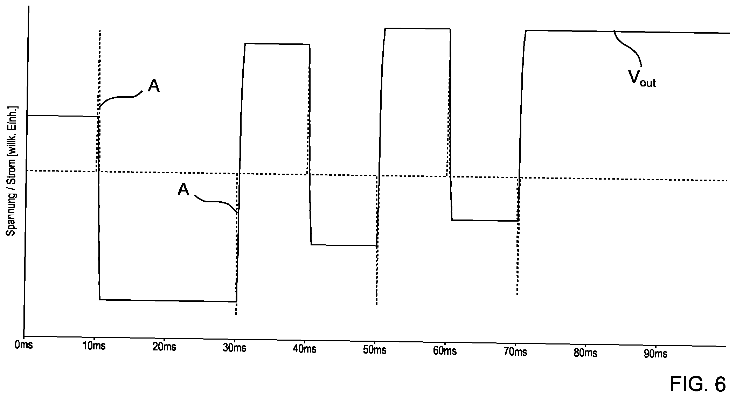

Fig. 6 zeigt einen zeitlichen Verlauf einer Kondensatorspannung Vₒᵤₜ der Schaltung aus Fig. 5. Bei einer Betätigung des Kraftsensors wird ein Auslöseimpuls A erzeugt, der zu einem umgekehrt proportional zur Kraft sinkenden Pegel führt. Bei einer Entlastung des Kraftsensors wird hingegen ein Auslöseimpuls A erzeugt, der zu einem Umladen des Kondensators und damit zu einem ansteigenden Pegel führt. Betätigung und Entlastung haben somit jeweils einen eigenen Spannungswert, der umgekehrt proportional zur Krafteinwirkung ist.

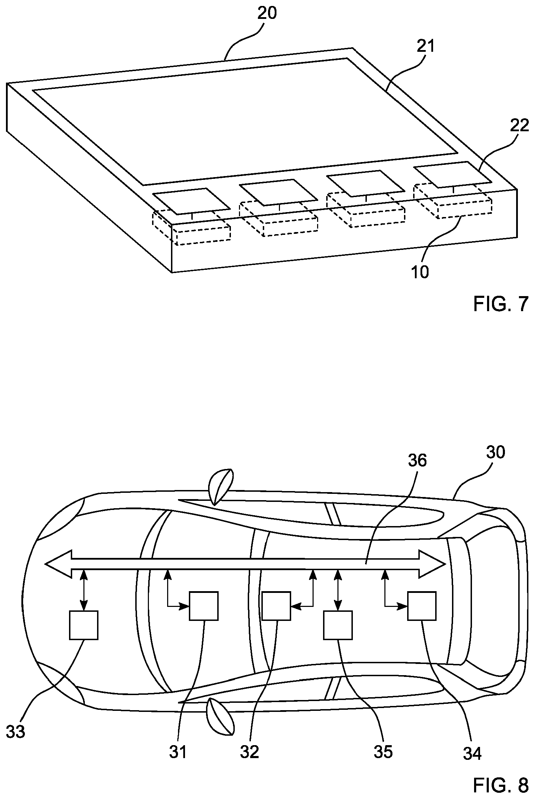

Fig. 7 zeigt schematisch ein Eingabegerät 20, das eine erfindungsgemäße Lösung nutzt. Das Eingabegerät 20 weist ein Display 21 zur Anzeige von Informationen auf. Das Display 21 kann mit einer Touch-Funktion ausgestattet sein. Zusätzlich weist das Eingabegerät 20 mehrere Bedientasten 22 auf, die jeweils einen in Fig. 7 nicht dargestellten piezoelektrischen Sensor zum Erfassen einer Nutzereingabe aufweisen. Die Signale der Bedientasten 22 werden jeweils von einer erfindungsgemäßen Vorrichtung 10 zur Messung einer Krafteinwirkung ausgewertet.

Fig. 8 zeigt schematisch eine Maschine 30, in der eine erfindungsgemäße Lösung realisiert ist. Bei der Maschine 30 handelt es sich in diesem Beispiel um ein Kraftfahrzeug. Das Kraftfahrzeug weist ein erfindungsgemäßes Eingabegerät auf, bei dem es sich in diesem Beispiel um eine berührungsempfindliche Anzeigevorrichtung 31 handelt, die in einer Armaturentafel angeordnet ist. Bei der Anzeigevorrichtung 31 kann es sich beispielsweise um ein Fahrerinformationsdisplay oder ein Zentraldisplay handeln. Ebenso ist eine Verwendung als Innenraumdisplay, Türdisplay oder Beifahrerdisplay möglich. Mit einer Sensorik 32 können Daten zur Fahrzeugumgebung erfasst werden. Die Sensorik 32 kann insbesondere Sensoren zur Umfelderkennung umfassen, z.B. Ultraschallsensoren, Laserscanner, Radarsensoren, Lidarsensoren oder Kameras. Die von der Sensorik 32 erfassten Informationen können genutzt werden, um anzuzeigende Inhalte für die Anzeigevorrichtung 31 zu generieren. Weitere Bestandteile des Kraftfahrzeugs sind in diesem Beispiel ein Navigationssystem 33, durch das Positionsinformationen bereitgestellt werden können, sowie eine Datenübertragungseinheit 34. Mittels der Datenübertragungseinheit 34 kann z.B. eine Verbindung zu einem Backend aufgebaut werden, beispielsweise um aktualisierte Software für Komponenten des Kraftfahrzeugs zu beziehen. Zur Speicherung von Daten ist ein Speicher 35 vorhanden. Der Datenaustausch zwischen den verschiedenen Komponenten des Kraftfahrzeugs erfolgt über ein Netzwerk 36.

### Bezugszeichenliste

- 10: Vorrichtung
- 11: Eingang
- 12: Ladungsverstärker
- 13: Komparatorschaltung
- 130: Komparator
- 131: Komparator
- 14: Stromspiegel
- 15: Auswerteeinheit
- 16: Kontrollmodul
- 17: Ausgang
- 18: Schnittstelle

- 20: Eingabegerät
- 21: Display
- 22: Bedientaste

- 30: Maschine
- 31: Anzeigevorrichtung
- 32: Sensorik
- 33: Navigationssystem
- 34: Datenübertragungseinheit
- 35: Speicher
- 36: Netzwerk

- A: Auslöseimpuls
- AZ: Ausgangszustand
- C: Kondensator
- S: Kraftsensor
- Vₒᵤₜ: Kondensatorspannung
- ZD: Zenerdiode

- S1: Generieren einer Ausgangsspannung
- S2: Generieren eines Auslöseimpulses
- S3: Speichern eines abgeleiteten Spannungswertes
- S4: Auswerten einer resultierenden Kondensatorspannung

## Patentansprüche

1. Verfahren zur Messung einer Krafteinwirkung, mit den Schritten:
- Generieren (S1) eines aus einer Krafteinwirkung auf einen Kraftsensor (S) resultierenden Spannungspulses mittels eines Ladungsverstärkers (12); und
- Speichern (S3) eines aus dem Spannungspuls abgeleiteten Spannungswertes; **dadurch gekennzeichnet, dass** das Speichern (S3) in einem Speicherkondensator (C) mittels eines Stromspiegels (14) erfolgt.

2. Verfahren gemäß Anspruch 1, wobei das Speichern (S3) des Spannungswertes im Speicherkondensator (C) durch einen Auslöseimpuls (A) einer Komparatorschaltung (13) ausgelöst wird.

3. Verfahren gemäß Anspruch 2, wobei die Komparatorschaltung (13) zwei Komparatoren (130, 131) aufweist, die das Speichern (S3) eines positiven und eines negativen aus dem Spannungspuls abgeleiteten Spannungswertes ermöglichen.

4. Verfahren gemäß einem der vorherigen Ansprüche, wobei der Kraftsensor (S) ein piezoelektrischer Sensor oder ein elektrodynamischer Sensor ist.

5. Vorrichtung (10) zur Messung einer Krafteinwirkung, mit:
- einem Ladungsverstärker (12) zum Generieren (S1) eines aus einer Krafteinwirkung auf einen Kraftsensor (S) resultierenden Spannungspulses; **dadurch gekennzeichnet, dass** die Vorrichtung (10) ferner aufweist:
- einen Stromspiegel (14) zum Speichern (S3) eines aus dem Spannungspuls abgeleiteten Spannungswertes in einem Speicherkondensator (C).

6. Vorrichtung (10) gemäß Anspruch 5, wobei die Vorrichtung (10) eine Komparatorschaltung (13) zum Generieren eines Auslöseimpulses (A) aufweist, durch den das Speichern (S3) des Spannungswertes im Speicherkondensator (C) ausgelöst wird

7. Vorrichtung (10) gemäß Anspruch 6, wobei die Komparatorschaltung (13) zwei Komparatoren (130, 131) aufweist, die das Speichern (S3) eines positiven und eines negativen aus dem Spannungspuls abgeleiteten Spannungswertes ermöglichen.

8. Vorrichtung (10) gemäß einem der Ansprüche 5 bis 7, wobei der Kraftsensor (S) ein piezoelektrischer Sensor oder ein elektrodynamischer Sensor ist.

9. Eingabegerät (20), wobei das Eingabegerät (20) eine Vorrichtung (10) gemäß einem der Ansprüche 5 bis 8 aufweist oder eingerichtet ist, ein Verfahren gemäß einem der Ansprüche 1 bis 4 zur Messung einer Krafteinwirkung auszuführen.

10. Eingabegerät (20) gemäß Anspruch 9, wobei das Eingabegerät (20) eine berührungsempfindliche Anzeigevorrichtung ist.

## Claims

1. A method for measuring a force action, comprising the following steps:
- generating (S1) a voltage pulse resulting from a force action on a force sensor (S) by means of a charge amplifier (12); and
- storing (S3) a voltage value derived from the voltage pulse; **characterized in that** the storing (S3) takes place in a storage capacitor (C) by means of a current mirror (14).

2. The method as claimed in claim 1, wherein the storing (S3) of the voltage value in the storage capacitor (C) is triggered by a trigger pulse (A) of a comparator circuit (13).

3. The method as claimed in claim 2, wherein the comparator circuit (13) comprises two comparators (130, 131), which enable the storing (S3) of a positive and a negative voltage value derived from the voltage pulse.

4. The method as claimed in any one of the preceding claims, wherein the force sensor (S) is a piezoelectric sensor or an electrodynamic sensor.

5. A device (10) for measuring a force action, comprising:
- a charge amplifier (12) for generating (S1) a voltage pulse resulting from a force action on a force sensor (S); **characterized in that** the device (10) furthermore comprises:
- a current mirror (14) for storing (S3) a voltage value derived from the voltage pulse in a storage capacitor (C).

6. The device (10) as claimed in claim 5, wherein the device (10) comprises a comparator circuit (13) for generating a trigger pulse (A), by means of which the storing (S3) of the voltage value in the storage capacitor (C) is triggered.

7. The device (10) as claimed in claim 6, wherein the comparator circuit (13) comprises two comparators (130, 131), which enable the storing (S3) of a positive and a negative voltage value derived from the voltage pulse.

8. The device (10) as claimed in any one of claims 5 to 7, wherein the force sensor (S) is a piezoelectric sensor or an electrodynamic sensor.

9. An input apparatus (20), wherein the input apparatus (20) comprises a device (10) as claimed in any one of claims 5 to 8 or is configured to carry out a method as claimed in any one of claims 1 to 4 for measuring a force action.

10. The input apparatus (20) as claimed in claim 9, wherein the input apparatus (20) is a touch-sensitive display device.

## Revendications

1. Procédé de mesure d'une force, comprenant les étapes :
- de génération (S1) d'une impulsion de tension résultant d'une force agissant sur un capteur de force (S) au moyen d'un amplificateur de charge (12) ; et
- de stockage (S3) d'une valeur de tension dérivée de l'impulsion de tension ; **caractérisé en ce que** le stockage (S3) dans un condensateur de stockage (C) est effectué au moyen d'un miroir de courant (14).

2. Procédé selon la revendication 1, dans lequel le stockage (S3) de la valeur de tension dans le condensateur de stockage (C) est déclenché par une impulsion de déclenchement (A) d'un circuit comparateur (13).

3. Procédé selon la revendication 2, dans lequel le circuit comparateur (13) présente deux comparateurs (130, 131) qui permettent le stockage (S3) d'une valeur de tension positive et d'une valeur de tension négative dérivée de l'impulsion de tension.

4. Procédé selon l'une quelconque des revendications précédentes, dans lequel le capteur de force (S) est un capteur piézoélectrique ou un capteur électrodynamique.

5. Dispositif (10) de mesure d'une force, comprenant :
- un amplificateur de charge (12) destiné à générer (S1) une impulsion de tension résultant d'une force agissant sur un capteur de force (S) ;
**caractérisé en ce que** le dispositif (10) présente également :
- un miroir de courant (14) pour stocker (S3) une valeur de tension dérivée de l'impulsion de tension dans un condensateur de stockage (C).

6. Dispositif (10) selon la revendication 5, dans lequel le dispositif (10) présente un circuit comparateur (13) pour générer une impulsion de déclenchement (A) par laquelle le stockage (S3) de la valeur de tension est déclenché dans le condensateur de stockage (C).

7. Dispositif (10) selon la revendication 6, dans lequel le circuit comparateur (13) présente deux comparateurs (130, 131) qui permettent le stockage (S3) d'une valeur de tension positive et d'une valeur de tension négative dérivée de l'impulsion de tension.

8. Dispositif (10) selon l'une quelconque des revendications 5 à 7, dans lequel le capteur de force (S) est un capteur piézoélectrique ou un capteur électrodynamique.

9. Appareil d'entrée (20), l'appareil d'entrée (20) comprenant un dispositif (10) selon l'une quelconque des revendications 5 à 8 ou étant configuré pour mettre en œuvre un procédé selon l'une quelconque des revendications 1 à 4 pour la mesure d'une force.

10. Appareil d'entrée (20) selon la revendication 9, dans lequel l'appareil d'entrée (20) est un dispositif d'affichage tactile.
